# EUROPEAN PATENT APPLICATION

(11) **EP 2 980 921 A1**
(43) Date of publication of application: **03.02.2016**
(21) Application number: 14773205.1
(22) Date of filing: 27.01.2014
(51) Int. Cl.: H01Q 1/44, H01M 10/44, H01M 10/48

(54) **BATTERY SYSTEM**

(30) Priority: 29.03.2013 JP 2013073180
(71) Applicant: Hitachi Automotive Systems, Ltd., Hitachinaka-shi, Ibaraki 312-8503 (JP)
(72) Inventor: IWASAWA Hiroshi, Tokyo 100-8280 (JP); TERADA Takahide, Tokyo 100-8280 (JP); KIKUCHI Mutsumi, Hitachinaka-shi Ibaraki 312-8505 (JP); YAMAZOE Takanori, Tokyo 100-8280 (JP); KANAI Tomonori, Hitachinaka-shi Ibaraki 312-8505 (JP); KUDO Akihiko, Hitachinaka-shi Ibaraki 312-8505 (JP); TAKEUCHI Takashi, Tokyo 100-8280 (JP)
(74) Representative: MERH-IP Matias Erny Reichl Hoffmann Patentanwälte PartG mbB
(86) International application number: PCT/JP2014/051612
(87) International publication number: WO 2014/156263

(57) **Abstract**

The present invention provides a battery system that is capable of transmitting the voltage value of each cell by means of wireless communication while suppressing costs and suppressing the number of components. The battery system 1 includes: cells 11a through 11d each having the positive electrode terminal 12P and the negative electrode terminal 12N; the voltage detection circuits 13 that detect the voltages of the cells 11a through 11d; the voltage detection lines 14 that connect each of the positive electrode terminal 12P and the negative electrode terminal 12N of the cells 11a through 11d to each voltage detection circuit 13; and the upper controller 31 that performs wireless communication with the voltage detection circuits 13 so as to receive, from each of the voltage detection circuits 13, the corresponding voltage of each cells 11a through 11d. The voltage detection line 14 functions as an antenna used to provide wireless communication between the voltage detection circuit 13 and the upper controller 31.

## Description

### TECHNICAL FIELD

The present invention relates to a battery system.

### BACKGROUND ART

With conventional battery systems for managing an assembled battery in which a plurality of cells are combined, a circuit configured to detect the voltage of each cell is provided in order to manage the state of each cell, and a means is used for transmitting the voltage of each cell thus detected by the circuit to an upper controller. Such a transmission means allows the upper controller to judge whether or not each cell is in an unsafe state such as an overcharged state or the like and, as necessary, to perform an operation such as current disconnection or the like, thereby preventing the risk level of such a cell from becoming higher.

Such a transmission means as described above may be configured in various forms. For example, a fuel cell state monitoring apparatus is disclosed in PLT 1, configured such that the voltage of each cell is acquired by a corresponding one of multiple internal circuits, and the voltage value thus acquired is transmitted to an external circuit by means of wireless communication. With such an arrangement, corresponding wiring and insulator elements can be omitted, thereby allowing the costs of materials and the size of the apparatus to be reduced as compared with an arrangement configured using wired communication.

### CITATION LIST

### PATENT LITERATURE

PLT 1: Japanese Laid-Open Patent Publication No. 2005-135762

### SUMMARY OF INVENTION

### TECHNICAL PROBLEM

With such a conventional technique described in PLT 1, a loop antenna is employed to provide wireless communication between the external circuit and the multiple internal circuits which detect the respective voltages of the corresponding cells. That is to say, a small loop antenna is connected to each internal circuit and a large loop antenna is connected to the external circuit, and these antennas are electromagnetically coupled in a many-to-one communication manner so as to provide wireless communication. However, such an arrangement requires each internal circuit to include such a wireless communication antenna, in addition to a circuit for detecting the voltage of each cell. This leads to increased costs and an increased number of circuit components.

The present invention has been made in view of such a situation. Accordingly, it is a main purpose of the present invention to provide a battery system that is capable of transmitting the voltage value of each cell by means of wireless communication while suppressing costs and suppressing the number of components.

### SOLUTION TO PROBLEM

A battery system according to a present invention comprises: a plurality of cells each having a positive electrode terminal and a negative electrode terminal; a voltage detection circuit that detects a voltage of the cell; voltage detection lines that are provided to each of the cells and that connect the positive electrode terminal and the negative electrode terminal of each cell to the voltage detection circuit; and an upper controller that performs wireless communication with the voltage detection circuit so as to receive a voltage value of each corresponding cell from the voltage detection circuit. The voltage detection lines each function as an antenna used to provide wireless communication between the voltage detection circuit and the upper controller.

### ADVANTAGEOUS EFFECT OF INVENTION

The present invention provides a battery system that is capable of transmitting the voltage value of each cell by means of wireless communication while suppressing costs and suppressing the number of components.

### BRIEF DESCRIPTION OF DRAWINGS

[Fig. 1] Fig. 1 is a plan view showing a configuration of a battery system according to a first embodiment of the present invention.
[Fig. 2] Fig. 2 is a plan view showing another example of a connection configuration of a voltage detection circuit board.
[Fig. 3] Fig. 3 is a schematic diagram showing a waveguide structure employed in the battery system according to the first embodiment of the present invention.
[Fig. 4] Fig. 4 is a wiring diagram showing the circuit block of the voltage detection circuit and the wiring relation between the voltage detection circuit, a cell, and a voltage detection line, according to the first embodiment of the present invention.
[Fig. 5] Fig. 5 is a circuit diagram showing an example configuration in which a high-frequency blocking element is configured as a resonance circuit.
[Fig. 6] Fig. 6 is a plan view showing a configuration of the battery system including multiple cell blocks according to the first embodiment of the present invention.
[Fig. 7] Fig. 7 is a plan view showing a configuration of a battery system according to a second embodiment of the present invention.
[Fig. 8] Fig. 8 is a wiring diagram showing the circuit block of the voltage detection circuit and the wiring relation between the voltage detection circuit, a cell, and a voltage detection line, according to the second embodiment of the present invention.
[Fig. 9] Fig. 9 is a circuit diagram showing an example configuration of a low-frequency separation circuit.
[Fig. 10] Fig. 10 is a plan view showing a configuration of a battery system according to a third embodiment of the present invention.
[Fig. 11] Fig. 11 is a plan view showing a configuration of a battery system according to a fourth embodiment of the present invention.
[Fig. 12] Fig. 12 is a plan view showing a configuration of a battery system according to a fifth embodiment of the present invention.
[Fig. 13] Fig. 13 is a wiring diagram showing the circuit block of the voltage detection circuit and the wiring relation between the voltage detection circuit, a cell, and a voltage detection line, according to a sixth embodiment of the present invention.
[Fig. 14] Fig. 14 is a circuit diagram showing an example configuration of a high-frequency short-circuiting circuit according to the sixth embodiment of the present invention.

### DESCRIPTION OF EMBODIMENTS

### (First embodiment)

Description will be made with reference to the drawings regarding a battery system according to a first embodiment of the present invention.

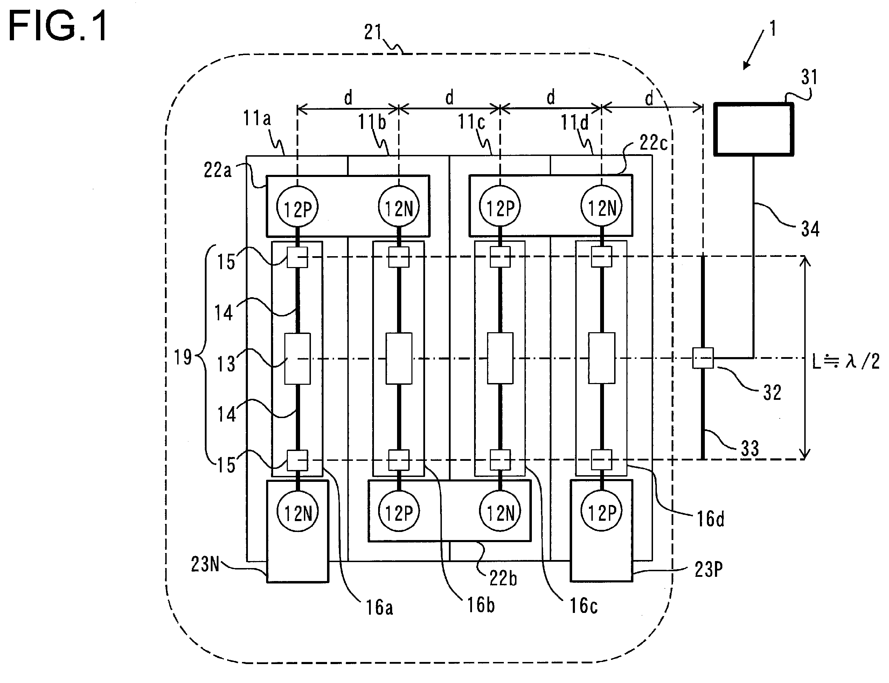

Fig. 1 is a plan view showing a configuration of a battery system 1 according to the first embodiment of the present invention. The battery system 1 is configured including a cell block 21, an upper controller 31, a wireless communication circuit 32, and an antenna 33.

The cell block 21 includes box-shaped (rectangular) battery cells 11a, 11b, 11c, and 11d, a positive conductor 23P, and a negative conductor 23N. The cells 11a through 11d are each housed in a can-type casing. A positive electrode terminal 12P, a negative electrode terminal 12N, and a voltage detection circuit board 16a are mounted on the top face of the casing of the cell 11a. In the same way, a positive electrode terminal 12P, a negative electrode terminal 12N, and a voltage detection circuit board 16b are mounted on the top face of the casing of the cell 11b. A positive electrode terminal 12P, a negative electrode terminal 12N, and a voltage detection circuit board 16c are mounted on the top face of the casing of the cell 11c. A positive electrode terminal 12P, a negative electrode terminal 12N, and a voltage detection circuit board 16d are mounted on the top face of the casing of the cell 11d.

The cells 11a through 11d are connected in series via bus bars 22a, 22b, and 22c. Specifically, the positive electrode terminal 12P of the cell 11a is connected to the negative electrode terminal 12N of the cell 11b via the bus bar 22a. Furthermore, the positive electrode terminal 12P of the cell 11b is connected to the negative electrode terminal 12N of the cell 11c via the bus bar 22b. Moreover, the positive electrode terminal 12P of the cell 11c is connected to the negative electrode terminal 12N of the cell 11d via the bus bar 22c. The negative electrode terminal 12N of the cell 11a, which is on the lowest electric potential side, is connected to the negative conductor 23N, and the positive electrode terminal 12P of the cell lid, which is on the highest electric potential side, is connected to the positive conductor 23P. It should be noted that the cells 11a through 11d are each configured as a lithium-ion secondary cell, for example.

A voltage detection circuit 13, a voltage detection line 14, and high-frequency cutoff elements 15 are mounted on each of the voltage detection circuit boards 16a through 16d. Each voltage detection circuit 13 is connected to the positive electrode terminal 12P and the negative electrode terminal 12N of the corresponding one of the cells 11a through 11d via the voltage detection line 14. The two high-frequency cutoff elements 13 are provided to the voltage detection line 14 such that one is interposed between the positive electrode terminal 12P and the voltage detection circuit 13 and the other is interposed between the negative electrode terminal 12N and the voltage detection circuit 13, and such that the voltage detection circuit 13 is interposed between the high-frequency cutoff elements 15.

It should be noted that the cells 11a through 11d each have the same configuration. Furthermore, the voltage detection circuit boards 16a through 16d each have the same configuration. In the following description, in some cases, the cells 11a through 11d will collectively be referred to simply as the "cells 11", and the voltage detection circuit boards 16a through 16d will collectively be referred to simply as the "voltage detection circuit boards 16".

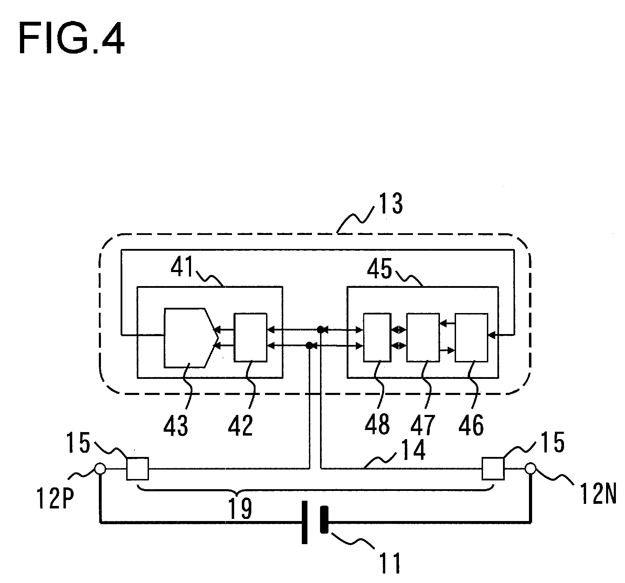

Each voltage detection circuit 13 is configured to measure the voltage of the corresponding cell 11, and to provide a communication function for transmitting the detection value to the upper controller 31 by means of wireless communication. Here, detailed description will be made later regarding the voltage detection circuit 13 with reference to Fig. 4.

The voltage detection line 14 connects the voltage detection circuit 13 and the positive electrode terminal 12P of the cell 11, and connects the voltage detection circuit 13 and the negative electrode terminal 12N of the cell 11. The voltage detection line 14 is preferably configured such that at least its inner portion with respect to the high-frequency cutoff elements 15, i.e., at least each portion from the voltage detection circuit 13 up to the corresponding high-frequency cutoff element 15, is configured as a circuit board pattern such as a copper foil pattern formed on the voltage detection circuit board 16. In contrast, each outer portion beyond the corresponding high-frequency cutoff element 15, i.e., a portion ranging between the corresponding high-frequency cutoff element 15 and the positive electrode terminal 12P and a portion ranging between the corresponding high-frequency cutoff element 15 and the negative electrode terminal 12N may be configured as a circular terminal (not shown) or the like for connecting the voltage detection circuit board 16 to the positive electrode terminal 12P or the negative electrode terminal 12N, in addition to a circuit board pattern as described above.

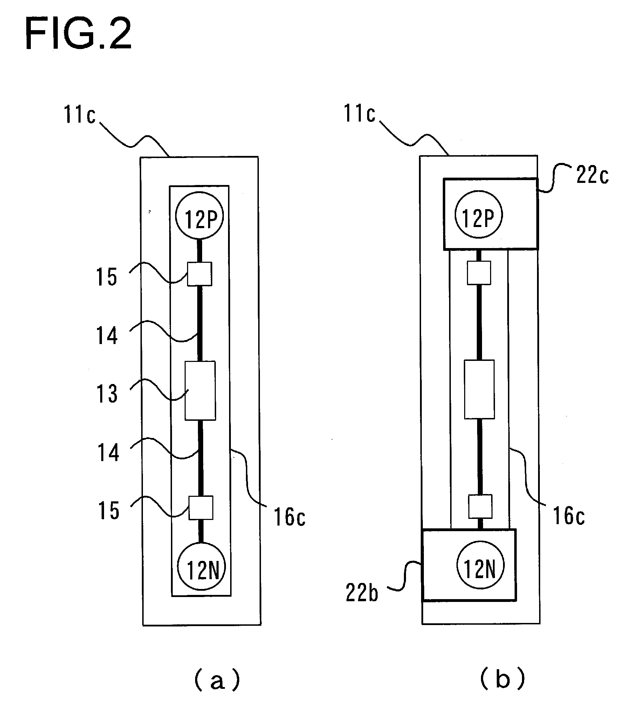

It should be noted that the connection structure for connecting the voltage detection circuit board 16 is not restricted to such a circular terminal. Fig. 2 is a plan view showing another example of the connection structure for connecting the voltage detection circuit board 16. Specifically, Fig. 2 shows another example of the connection structure for connecting the voltage detection circuit board 16c provided corresponding to the cell 11c to the positive electrode terminal 12P and the negative electrode terminal 12N of the cell 11c.

As shown in Fig. 2(a), the voltage detection circuit board 16c is configured such that it partially overlaps the positive electrode terminal 12P and the negative electrode terminal 12N. Two openings are provided to the voltage detection circuit board 16c such that one is formed at a position that corresponds to the positive electrode terminal 12P, and the other is formed at a position that corresponds to the negative electrode terminal 12N. Furthermore, as shown in Fig. 2(b), the voltage detection line 14 arranged around the circumference of each opening is fixed together with the corresponding bus bar 22b or 22c. This allows the voltage detection circuit 16c to be connected to the positive electrode terminal 12P and the negative electrode terminal 12N, and allows the positive electrode terminal 12P and the negative electrode terminal 12N to be connected to the bus bars 22c and 22b, respectively.

It should be noted that description has been made with reference to Fig. 2 regarding the connection structure for connecting the cell 11c and the voltage detection circuit board 16c as a representative example. Also, the same or a similar connection structure may be employed for connecting the other cells 11a, 11b, and 11d and the corresponding voltage detection circuit boards 16a, 16b, and 16d. It should be noted that the negative electrode terminal 12N of the cell 11a is fixed together with the negative conductor 23N, and the positive electrode terminal 12P of the cell 11d is fixed together with the positive conductor 23P.

Each high-frequency cutoff element 15 is an element that cuts off a current having a predetermined high frequency. Specifically, the high-frequency cutoff element 15 is configured to have electric characteristics such that it has low impedance with respect to a DC current for voltage measurement, thereby allowing such a DC current to pass through, and such that it has high impedance with respect to a high-frequency current used to perform wireless communication between the voltage detection circuit 13 and the upper controller 31, thereby cutting off such a high-frequency current. That is to say, by cutting off such a high-frequency current using the high-frequency cutoff elements 15, the effective length L of the antenna is determined in the voltage detection line 14 so that the voltage detection line 14 is employed as an antenna for wireless communication. As described above, the high-frequency cutoff elements 15 allow a part of the voltage detection line 14 to function as a dipole antenna.

As described above, a part of the voltage detection line 14 interposed between the two high-frequency cutoff elements 15 via the voltage detection circuit 13 also functions as a dipole antenna for wireless communication. Accordingly, in the following description, such a part will be particularly referred to as an "antenna portion 19". By providing wireless communication between each voltage detection circuit 13 and the upper controller 31 by means of the antenna portion 19, each voltage detection circuit 13 is capable of transmitting the voltage measurement result for the corresponding cell 11 to the upper controller 31. Thus, there is no need to provide each voltage detection circuit 13 with an additional antenna for wireless communication. Thus, such an arrangement provides a battery system which is capable of transmitting the voltage information with respect to each cell 11 by means of wireless communication while suppressing an increase in costs and an increase in the number of components.

Each antenna portion 19 that corresponds to the cell 11 is arranged according to the following position relation in order to provide a waveguide structure as described later. That is to say, the antenna portions 19 are arranged in parallel at regular intervals d as shown in Fig. 1. Furthermore, the center of each antenna portion 19 is arranged on approximately the same flat plane. Here, the arrangement of the antenna portions 19 is not restricted to such an arrangement that is in parallel with the drawing in Fig. 1. Also, the antenna portions 19 may be arranged on an inclined plane with respect to the drawing. Also, the centers of the respective antenna portions 19 may be arranged on approximately the same curved plane, instead of being arranged on approximately the same flat plane. In this case, the curvature of the curved plane may be determined based on the frequency of a wireless signal used in the wireless communication. It should be noted that, in order to transmit such a wireless signal with high efficiency, the antenna portions 19 are preferably arranged in as linear a fashion as possible.

Each antenna portion 19 has a linear structure, and has a length L that can be determined based on the wavelength of the wireless signal used in the wireless communication. Specifically, with the wavelength of the carrier wave used in the wireless communication as λ, L is approximately represented by λ/2. That is to say, L is preferably set to a length that is approximately half the wavelength λ of the carrier wave. Furthermore, the interval d between the adjacent antenna portions 19 may be determined based on the wavelength λ. Specifically, the interval d is preferably set to a value ranging between λ/8 and λ/4, and is more preferably set to approximately λ/4.

The upper controller 31 is configured as a control apparatus on which a microcontroller or the like is mounted. The upper controller 31 generates an instruction signal by means of an operation of the microcontroller, which instructs each voltage detection circuit 13 to detect the voltage value of the corresponding cell 11. Furthermore, the upper controller 31 performs judgment with respect to the state of charge of each cell 11 based on the voltage value of the cell 11 transmitted from each voltage detection circuit 13 received as a response to the instruction signal. For example, the upper controller 31 judges whether or not each cell 11 is in an unsafe state such as an overcharged state or the like.

After the judgment with respect to the state of charge of each cell 11, the upper controller 31 performs a charging/discharging control operation by the battery system 1 as necessary based on the judgment result. For example, in a case in which judgment has been made that a given cell 11 is in an overcharged state, the upper controller 31 transmits the judgment result to an apparatus, e.g., an inverter apparatus (not shown), to be charged or discharged by the battery system 1, so as to suspend the charging/discharging operation of the apparatus. Also, the upper controller 31 may perform a control operation so as to turn off a switch (not shown) provided on a wiring path between the apparatus and the battery system 1, thereby cutting off the flow of the charging/discharging current. By providing such a control operation, such an arrangement is capable of preventing the risk level of such a cell 11 from becoming higher.

The upper controller 31 is connected to the wireless communication circuit 32 and the antenna 33 via wiring 34, in order to provide mutual wireless communication between it and each voltage detection circuit 13. When a wireless signal is transmitted from any one of the voltage detection circuits 13 by means of the antenna portion 19 as described above, the antenna 33 outputs a high-frequency signal obtained by receiving the wireless signal to the wireless communication circuit 32. The wireless communication circuit 32 includes a modulation/demodulation circuit, demodulates the high-frequency signal output via the antenna 33 so as to generate a reception signal, and outputs the reception signal thus generated to the upper controller 31 via the wiring 34. When a transmission signal is output to each voltage detection circuit 13 from the upper controller 31 via the wiring 34, the wireless communication circuit 32 modulates the transmission signal so as to generate a high-frequency signal, and outputs the high-frequency signal thus generated to the antenna 33. The antenna 33 wirelessly transmits the high-frequency signal output from the wireless communication circuit 32 to each voltage detection circuit 13. Such an arrangement allows the upper controller 31 to perform wireless communication between itself and each voltage detection circuit 13. The wireless communication may be performed using various known modulation methods such as an FM (frequency modulation) method, an AM (amplitude modulation) method, or the like. It should be noted that the wireless communication circuit 32 may be configured simply as an impedance matching circuit. In this case, such a modulation/demodulation circuit may be included in the upper controller 31, instead of being included in the wireless communication circuit 32.

The antenna 33 is configured as a dipole antenna in the same way as the antenna portion 19. The antenna 33 is preferably configured to have a length L that is approximately equal to λ/2. Furthermore, the antenna 33 is arranged in parallel with the antenna portion 19 that corresponds to the cell 11d closest to the antenna 33 in the cell block 21. The interval between the nearest antenna portion 19 and the antenna 33 is preferably set to d ≈ λ/4, in the same way as the interval set between the adjacent antenna portions 19. That is to say, the antenna 33 is arranged as an extension of the antenna portions 19 according to the same position relation.

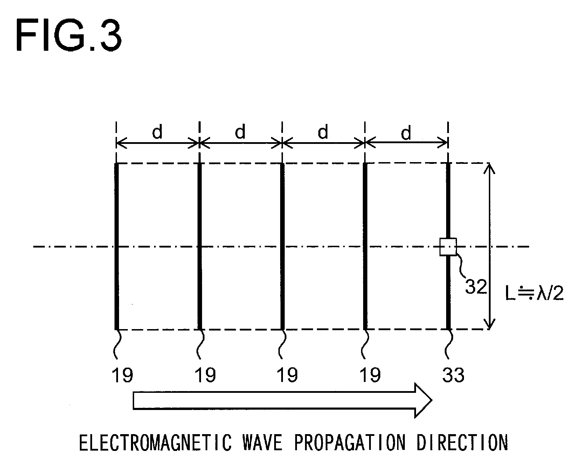

Here, description will be made with reference to Fig. 3 regarding the waveguide structure for the battery system 1. Fig. 3 is a schematic diagram showing the waveguide structure for the battery system 1 according to the first embodiment of the present invention. Specifically, Fig. 3 shows the waveguide structure in which the antenna portions 19 and the antenna 33 each having a length L ≈ λ/2 are arranged in parallel with each other at regular intervals d, and the centers of the antennas are arranged along approximately the same flat plane (a plane that includes a line represented by the line of alternately long and short dashes and that is orthogonal to the drawing). That is to say, the antennas may be arranged at the same height or otherwise different heights with respect to the drawing. In this case, the entire region of each antenna may be arranged along approximately the same flat plane, in addition to the center of each antenna.

Alternatively, the centers of the respective antennas may be arranged on the same curved plane, instead of being arranged on the same flat plane as described above. In this case, the curvature of the curved plane may be determined based on the frequency of the carrier wave used in the wireless communication. Specifically, the curvature of the curved plane may be increased according to a reduction in the frequency of the carrier wave. It should be noted that, in Fig. 3, the wireless communication circuit 32 connected to the antenna 33 is shown. However, the voltage detection circuit 13 and the like included in each antenna portion 19 are not shown.

With such a waveguide structure shown in Fig. 3, the interval d between the adjacent antennas is preferably set to approximately λ/4, as described above. Also, the interval may be set to other values. The value to be set for the interval d changes according to the frequency of the wireless communication, the effect of surrounding structures, and the like. Typically, the interval d may be set to a value ranging between λ/8 and λ/4. In the drawing, the arrow represents the propagation direction of electromagnetic waves when a wireless signal is transmitted from each antenna portion 19 to the antenna 33.

It is known that the waveguide structure as described above exhibits waveguide characteristics that allow electromagnetic waves to pass through with high efficiency in the horizontal direction in the drawing. For example, such a waveguide structure is employed as a Yagi-Uda antenna, which can be used as a TV antenna or the like. That is to say, by determining the position relation between the antenna portions 19 and the antenna 33 so as to satisfy the condition of the waveguide structure as shown in Fig. 3, such a waveguide structure functions as an antenna set that provides the wireless communication circuit 32 with strong directionality and high gain in the horizontal direction. As a result, such an arrangement allows electromagnetic waves to propagate with high efficiency. Thus, such an arrangement requires only small radiation power to transmit the voltage measurement result for each cell 11 from each voltage detection circuit 13 to the upper controller 31 by means of wireless communication.

It should be noted that, in general, power consumption required by such a battery system is preferably as small as possible. This is because there is a need to prevent the battery from being discharged due to its power consumption as much as possible in addition to the viewpoint of power saving. Thus, in a case in which the voltage measurement result for each cell 11 is transmitted by means of wireless communication, the transmission power is preferably reduced as much as possible so as to suppress power consumption. By suppressing the transmission power, such an arrangement is capable of reducing the level of electromagnetic waves that leak to an external circuit, thereby preventing electromagnetic-wave interference between it and an external device, thereby providing a more preferable battery system. Thus, by employing the waveguide structure as described above, such an arrangement allows electromagnetic waves to propagate with high efficiency, thereby reducing transmission power. This suppresses power consumption, and contributes to preventing interference between the battery system and an external device.

Next, description will be made with reference to Fig. 4 regarding the operation of the voltage detection circuit 13 and peripheral circuits. Fig. 4 is a wiring diagram showing a circuit block of the voltage detection circuit 13 and a wiring relation between the voltage detection circuit 13, the cell 11, and the voltage detection line 14 according to the first embodiment of the present invention.

The voltage detection circuit 13 is configured including a DC voltage detection circuit 41 and a wireless communication circuit 45. The DC voltage detection circuit 41 is configured including a low-pass filter 42 and an A/D converter 43. The DC voltage detection circuit 41 is connected to the positive electrode terminal 12P and the negative electrode terminal 12N of the cell 11 via the voltage detection line 14 and the high-frequency cutoff elements 15.

The low-pass filter 42 cuts off a high-frequency signal having a higher frequency than a predetermined frequency, which is a component of a signal input from the voltage detection line 14 to the DC voltage detection circuit 41. Specifically, when the voltage detection circuit 13 transmits a wireless signal, the low-pass filter 42 cuts off a high-frequency signal output from the wireless communication circuit 45 to the antenna portion 19. Furthermore, when the voltage detection circuit 13 receives a wireless signal, the low-pass filter 42 cuts off a high-frequency signal input from the antenna portion 19 to the voltage detection circuit 13. This allows the A/D converter 43 to measure, with high precision, the voltage of the battery cell 11, which is a DC signal. Furthermore, the low-pass filter 42 has a function for cutting off AC noise that occurs due to an inverter or the like connected to the battery system 1.

The A/D converter 43 converts the voltage of the battery cell 11 applied via the low-pass filter 42, i.e., the voltage that develops between the positive electrode terminal 12P and the negative electrode terminal 12N, into a digital value, and outputs the digital value thus converted to the wireless communication circuit 45.

The wireless communication circuit 45 is configured including a communication control unit 46, a modulation/demodulation circuit 47, and a matching circuit 48. The wireless communication circuit 45 is connected to the voltage detection line 14 (antenna portion 19).

Upon reception of a wireless signal from the upper controller 31, the communication control unit 46 controls the A/D converter 43 according to a measurement instruction included in the reception signal output from the modulation/demodulation circuit 47, so as to instruct the A/D converter 43 to measure the voltage of the cell 11. Subsequently, the communication control unit 46 performs predetermined encoding processing or the like so as to generate a transmission signal based on the voltage value of the cell 11 output from the A/D converter 43, and outputs the transmission signal thus generated to the modulation/demodulation circuit 47.

Upon reception of a wireless signal, the modulation/demodulation circuit 47 demodulates a high-frequency signal obtained by receiving, via the antenna portion 19, the wireless signal transmitted from the upper controller 31 so as to generate a reception signal, and outputs the reception signal thus generated to the communication control unit 46. When a wireless signal is to be transmitted, the modulation/demodulation circuit 47 modulates the transmission signal output from the communication control unit 46 so as to generate a high-frequency signal used for wireless communication, and outputs the high-frequency signal thus generated to the antenna portion 19. This allows a wireless signal to be transmitted from the antenna portion 19 to the upper controller 31.

The matching circuit 48 is connected to the antenna portion 19. The matching circuit 48 has a function for absorbing the difference in high-frequency impedance between the wireless communication circuit 45 and the antenna portion 19 of the voltage detection line 14. That is to say, the matching circuit 48 provides a function for inputting/outputting high-frequency electric power between the modulation/demodulation circuit 47 and the antenna portion 19 with high efficiency.

As described above, the voltage detection circuit 13 emits high-frequency electric power in the form of a wireless signal to the surrounding space via the antenna portion 19. The high-frequency electric power propagates in this space via the waveguide structure as shown in Fig. 3, and is received via the antenna 33 connected to the upper controller 31. By providing such wireless communication between the voltage detection circuit 13 and the antenna 33 as described above, such an arrangement allows the voltage value of the cell 11 to be transmitted from the voltage detection circuit 13 to the upper controller 31.

It should be noted that, as such a high-frequency cutoff element 15, an inductor may be employed as a discrete component, for example. Also, a coil structure may be formed of a copper foil pattern configured as the voltage detection line 14 on the voltage detection circuit board 16, which provides such a high-frequency cutoff element 15 mounted on the voltage detection circuit board 16 without any discrete components.

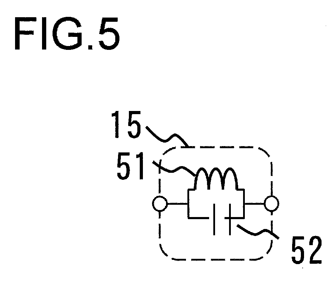

Also, in a case in which the high-frequency cutoff element 15 is required to provide a very high cutoff capability, the high-frequency cutoff element 15 may be configured as a resonance circuit. Fig. 5 is a circuit diagram showing an example configuration of the high-frequency cutoff element 15 configured as a resonance circuit. In the circuit diagram shown in Fig. 5, the high-frequency cutoff element 15 is configured as a resonance circuit comprising an inductor 51 and a capacitor 52 connected in parallel. The resonance frequency of the resonance circuit is preferably set to approximately the same value as that of the carrier wave for wireless communication. That is to say, with the inductance of the inductor 51 as Lr, and with the electrostatic capacitance of the capacitor 52 as Cr, the relation between Lr, Cr, and the frequency f of the carrier wave is preferably represented by f ≈ 1/2π√(Lr · Cr). By selecting the inductor 51 and the capacitor 52 so as to satisfy this relation, such an arrangement is capable of suppressing the leakage of high-frequency current from the high-frequency cutoff element 15 to the exterior, thereby allowing the length L of the antenna portion 19 to be strictly determined. As a result, such an arrangement provides further improved transmission efficiency for transmitting electromagnetic waves.

The above is a description of the configuration of the battery system 1 according to the first embodiment of the present invention, configured to transmit the voltage of each cell 11 to the upper controller 31. Such a configuration is capable of reducing required power consumption and reducing leakage of electromagnetic waves to an external circuit in wireless communication for transmitting the detected voltage of each cell 11 to the upper controller 31.

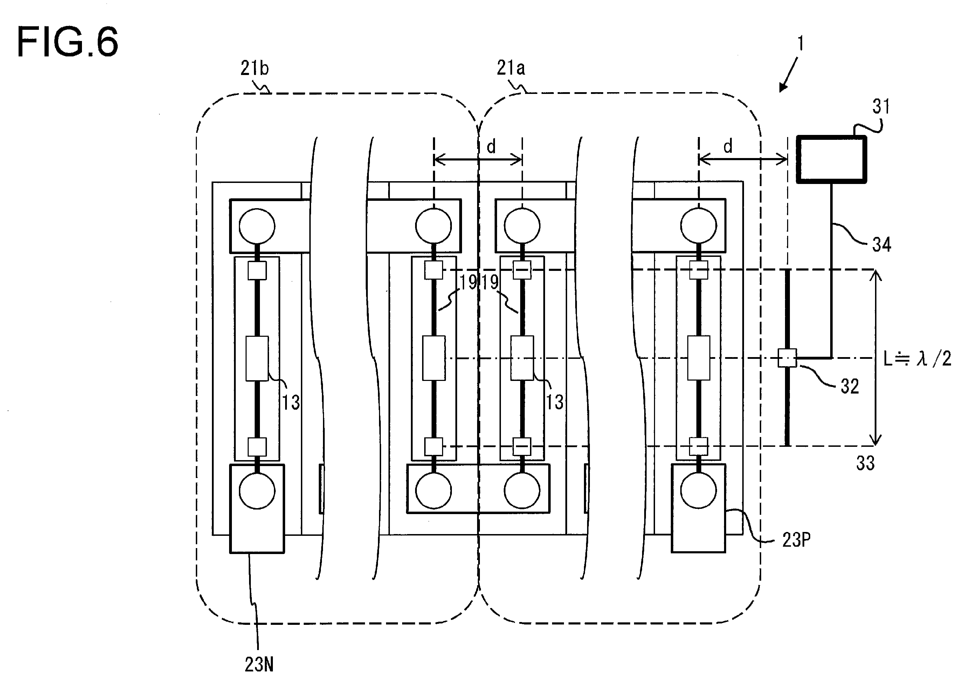

It should be noted that description has been made above regarding an arrangement in which a single cell block 21 is connected to the upper controller 31. However, the present embodiment can be easily extended to an arrangement in which multiple cell blocks 21 are connected to a single upper controller 31. Description will be made below regarding a specific example with reference to Fig. 6.

Fig. 6 is a plan view showing a configuration of a cell system 1 including multiple cell blocks 21a and 21b according to the first embodiment of the present invention. In Fig. 6, the second cell block 21b is further arranged adjacent to the first cell block 21a, in addition to the cell block 21a that is wirelessly connected to the upper controller 31 via the waveguide structure as described above. In this arrangement, the cell blocks 21a and 21b are arranged such that the adjacent antenna portions 19 of the respective cell blocks 21a and 21b, which are positioned closest to each other, are arranged according to the same position relation as the other antenna portions 19, and specifically, are arranged in parallel with each other at the same interval d. Such an arrangement provides the cell block 21b with wireless communication between each voltage detection circuit 13 and the upper controller 31 as well.

It should be noted that the wavelength λ of the carrier wave used as a basis of the size in the description represents the wavelength at the center frequency of the carrier wave used in the wireless communication. The wavelength λ changes due to interference between the antenna portions 19 and the effect of a dielectric in the vicinity of the antenna portion 19. Thus, it should be noted that the wavelength λ of the carrier wave cannot be represented by simply dividing the speed of light in a vacuum by the center frequency of the carrier wave.

As an example for describing the relation between the center frequency of the carrier wave and the wavelength λ, electromagnetic field analysis simulation was performed in order to calculate an optimum value of the wavelength λ for such an arrangement of the antenna portions 19 as described in the present embodiment in a case in which the carrier wave is configured to have a center frequency of 2.45 GHz. As a result of the simulation, it has been calculated that, in a case in which there is no dielectric in the vicinity of the antenna portions 19, i.e., in a case in which all the materials have a relative permittivity of 1, the optimum value of the wavelength λ is approximately 95 mm. In contrast, it has been calculated that, in a case in which there is a dielectric having the same width as that of the antenna portions 19, a thickness of 1.6 mm, and a relative permittivity of 5 arranged immediately below the antenna portions 19 (which corresponds to a case in which the voltage detection circuit board 16 is configured as a glass epoxy substrate), the optimum value of the wavelength λ is approximately 69 mm. As described above, it has been confirmed that the wavelength λ changes due to interference between the antenna portions 19 and the effect of a dielectric in the vicinity, as compared with the value (approximately 122 mm) obtained by dividing the speed of light in a vacuum by the center frequency.

With the first embodiment of the present invention described above, the following effects and advantages are provided.
(1) The battery system 1 includes: a plurality of cells 11 each having the positive electrode terminal 12P and the negative electrode terminal 12N; the voltage detection circuits 13 that detect the voltages of the cells 11; the voltage detection lines 14 that are provided to each of the cells 11 and that connect the positive electrode terminal 12P and the negative electrode terminal 12N of each cell 11 to the voltage detection circuit 13; and the upper controller 31 that performs wireless communication with the voltage detection circuits 13 so as to receive, from the voltage detection circuits 13, the voltage of each corresponding cell 11. With the battery system 1, each voltage detection line 14 functions as an antenna used to provide wireless communication between the voltage detection circuit 13 and the upper controller 31. Thus, such an arrangement provides a battery system which is capable of transmitting the voltage of each cell 11 by means of wireless communication while suppressing an increase in costs and an increase in the number of components.
(2) Each voltage detection line 14 is provided with high-frequency cutoff elements 15 that cut off a predetermined high-frequency current between the positive electrode terminal 12P and the voltage detection circuit 13 and between the negative electrode terminal 12N and the voltage detection circuit 13 respectively. A part of the voltage detection line 14 interposed between the high-frequency cutoff elements 15 provides the antenna portion 19 that functions as an antenna. Such an arrangement is capable of removing the effect of the high-frequency signal on the cell 11 when the voltage detection line 14 functions as an antenna. Furthermore, such an arrangement defines the length of a part that functions as an antenna with high precision.
(3) Each antenna portion 19 is preferably configured to have a linear structure having a length L which is approximately the same as half the wavelength λ of the carrier wave used in the wireless communication. Such an arrangement allows a wireless signal to propagate with high efficiency in the wireless communication.
(4) Also, the antenna portions 19 that respectively correspond to the multiple cells 11 may be arranged in parallel at regular intervals d. Also, the centers of the respective antenna portions 19 that respectively correspond to the multiple cells 11 may be arranged on approximately the same plane. Such an arrangement allows a wireless signal to propagate with higher efficiency in the wireless communication.
(5) As shown in Fig. 5, each high-frequency cutoff element 15 may be configured as a resonance circuit comprising the inductor 51 and the capacitor 52 connected in parallel. In this case, such an arrangement is capable of setting the resonance frequency of the resonance circuit to approximately the same value as that of the frequency f of the carrier wave used in the wireless communication. Such an arrangement is capable of removing, at a maximum level, the effect of the high-frequency signal on the cell 11 in the wireless communication.
(6) The voltage detection circuit 13 includes the wireless communication circuit 45 that generates a wireless signal modulated according to the voltage of the cell 11. The wireless signal is transmitted from the wireless communication circuit 45 to the upper controller 31, thereby providing wireless communication. Thus, such an arrangement allows the information with respect to the voltage of each cell 11 to be transmitted from the voltage detection circuit 13 to the upper controller 31 in a sure manner.

### [Second embodiment]

Next, description will be made with reference to the drawings regarding a battery system according to a second embodiment of the present invention. Description will be made in the present embodiment regarding an example in which a single voltage detection circuit 13A is shared by all the cells 11 included in the cell block 21, as an example obtained by reducing the circuit scale as compared with the first embodiment. From the viewpoint of reducing the circuit scale, such an arrangement allows the circuit costs to be reduced as compared with an arrangement in which a dedicated voltage detection circuit 13 is provided to each cell 11 as the first embodiment.

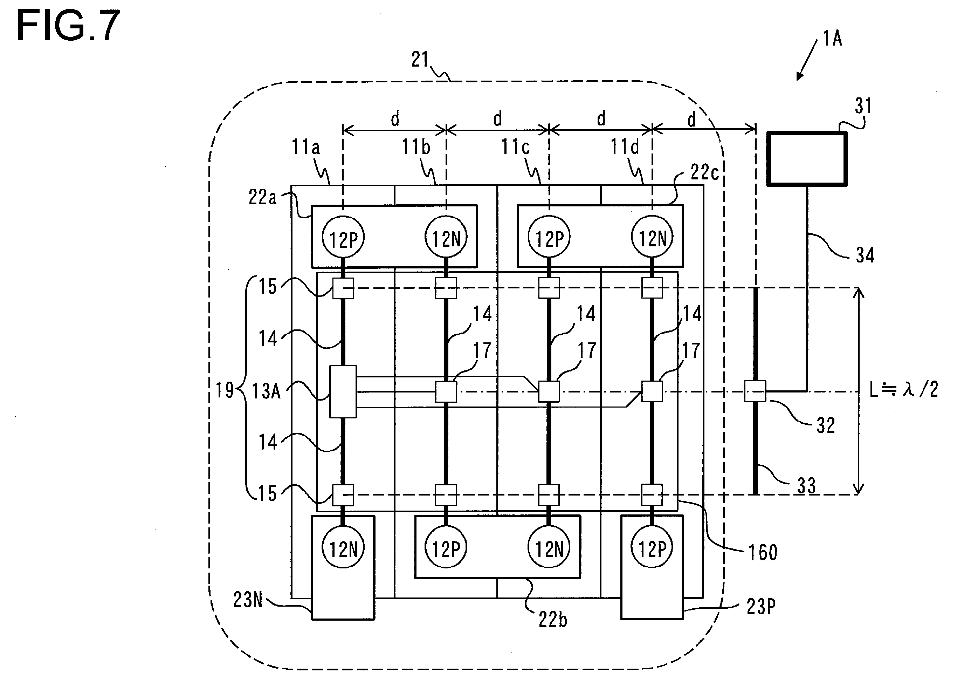

Description will be made with reference to Fig. 7 regarding a configuration of a battery system 1A according to the present embodiment. Fig. 7 is a plan view showing the configuration of the battery system 1A according to the second embodiment of the present invention. The point of difference between the battery system 1A and the battery system 1 shown in Fig. 1 described in the first embodiment is that the battery system 1A has a configuration in which a single voltage detection circuit board 160 is shared by all the cells 11a, 11b, 11c, and 11d.

The voltage detection circuit board 160 according to the present embodiment is equipped with a single voltage detection circuit 13A shared by the cells 11a through 11d, and three low-frequency separation circuits 17. Each low-frequency separation circuit 17 is connected to the positive electrode terminal 12P and the negative electrode terminal 12N of the corresponding cell 11b, 11c, or 11d via the voltage detection line 14. Wiring is provided between the voltage detection circuit 13A and each low-frequency separation circuit 17. Each low-frequency separation circuit 17 is connected to the voltage detection circuit 13A via the wiring.

Two high-frequency cutoff elements 15 are provided to a path of a voltage detection line 14 such that one is interposed between the positive electrode terminal 12P and the voltage detection circuit 13A or otherwise the low-frequency separation circuit 17, and the other is interposed between the negative electrode terminal 12N and the voltage detection circuit 13A or otherwise the low-frequency separation circuit 17, in the same manner as shown in Fig. 1.

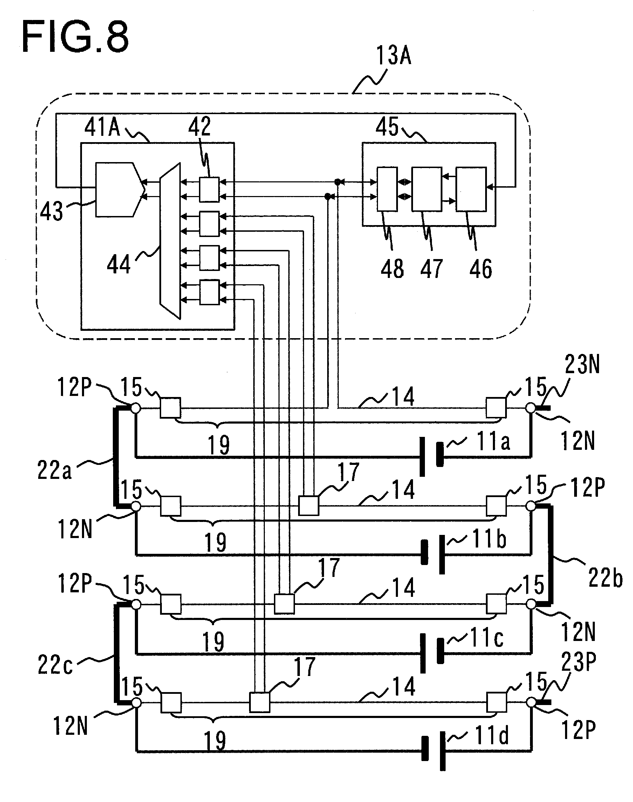

The voltage detection circuit 13A is a circuit that measures the voltage of each of the cells 11a, 11b, 11c, and 11d, and that transmits the measurement values to the upper controller 31, as with the voltage detection circuit 13 described in the first embodiment. It should be noted that detailed description of the present circuit will be made later with reference to Fig. 8.

Each low-frequency separation circuit 17 is a circuit having characteristics for a connection between the positive electrode terminal 12P and the negative electrode terminal 12N which are the opposite of those of the high-frequency cutoff element 15. Specifically, the low-frequency separation circuit 17 is configured to have characteristics such that it exhibits high impedance for a DC current used to measure the voltage so as to cut off the DC current. In addition, the low-frequency separation circuit 17 is configured to have characteristics such that it exhibits low impedance for a high-frequency current used to perform wireless communication between the voltage detection circuit 13 and the upper controller 31 so as to allow the high-frequency current to pass through. In contrast, the low-frequency separation circuit 17 has characteristics for a connection between it and the voltage detection circuit 13A such that a DC current passes through with high efficiency. By configuring the low-frequency separation circuit 17 to have such characteristics, the low-frequency separation circuit 17 has a function for defining a part of the voltage detection line 14 to be used as an antenna, as with the high-frequency cutoff elements 15. It should be noted that detailed description will be made later with reference to Fig. 8 regarding the present circuit.

In the present embodiment, as with the first embodiment, a part of the voltage detection line 14 interposed between the two high-frequency cutoff elements 15 via the voltage detection circuit 13 or otherwise the low-frequency separation circuit 17 will be referred to as the "antenna portion 19". Each antenna portion 19 is arranged in the same way as described in the first embodiment.

Next, description will be made with reference to Fig. 8 regarding the operations of the voltage detection circuit 13A, the low-frequency separation circuit 17, and the peripheral circuit according to the present embodiment. Fig. 8 is a wiring diagram showing the circuit block of the voltage detection circuit 13A and the wiring relation between the voltage detection circuit 13A, the cells 11a, 11b, 11c, and lid, and the voltage detection lines 14 according to the second embodiment of the present invention.

The voltage detection circuit 13A comprises a DC voltage detection circuit 41A and a wireless communication circuit 45. The point of difference between the DC voltage detection circuit 41A and the DC voltage detection circuit 41 according to the first embodiment shown in Fig. 4 is that the voltage detection circuit 41A includes low-pass filters 42 respectively provided to the cells 11a through 11d, and that the voltage detection circuit 41A includes a multiplexer 44 arranged between the low-pass filters 42 and the A/D converter 43. The DC voltage detection circuit 41A is connected to the positive electrode terminal 12P and the negative electrode terminal 12N of each of the cells 11a through 11d via the corresponding voltage detection line 14, high-frequency cutoff elements 15, and low-frequency separation circuit 17, provided to each of the cells 11a through 11d.

The voltage across the positive electrode terminal 12P and the negative electrode terminal 12N of each of the cells 11a through 11d is input to the multiplexer 44 via the corresponding low-frequency separation circuit 17 and low-pass filter 42. The multiplexer 44 is a circuit configured to sequentially switch the input voltage of the cell to be measured between the voltages of the cells 11a through 11d. The multiplexer 44 is configured as an analog switch or the like. The voltage of the cell selected by the multiplexer 44 is input to the A/D converter 43. The A/D converter 43 converts the voltage thus input into a digital value, thereby measuring the voltage value of each cell. The voltage value of each cell thus measured is output from the A/D converter 43 to the wireless communication circuit 45. Such an operation is sequentially performed for the cells 11a through 11d, thereby allowing the voltage detection circuit 13A to measure the voltage of each of the cells 11a through 11d.

It should be noted that the wireless communication circuit 45 according to the present embodiment has the same configuration as that described in the first embodiment with reference to Fig. 4. The wireless communication circuit 45 sequentially transmits the voltage values of the four cells 11a through 11d sequentially input from the A/D converter 43 according to the operation of the multiplexer 44 to the upper controller 31 by means of wireless communication using the antenna portions 19. The other operations are performed in the same way as in the first embodiment.

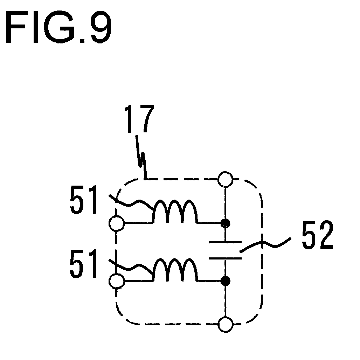

Fig. 9 is a circuit diagram showing an example configuration of the low-frequency separation circuit 17. As shown in Fig. 9, the low-frequency separation circuit 17 may be configured as a circuit obtained by combining two inductors 51 and a capacitor 52, for example.

With the second embodiment of the present invention described above, such an arrangement provides the same effects and advantages as those provided by the first embodiment. Furthermore, such an arrangement requires only a single voltage detection circuit 13A to transmit the voltage values of all the cells 11a through 11d included in the cell block 21 to the upper controller 31. Thus, such an arrangement allows the number of circuit components and number of manufacturing steps to be reduced, thereby providing reduced costs.

### [Third embodiment]

Next, description will be made below with reference to the drawings regarding a battery system according to a third embodiment of the present invention. Description will be made in the present embodiment regarding an arrangement in which the cell 11 is provided with a gas release vent 18, thereby providing improved safety of the overall battery system.

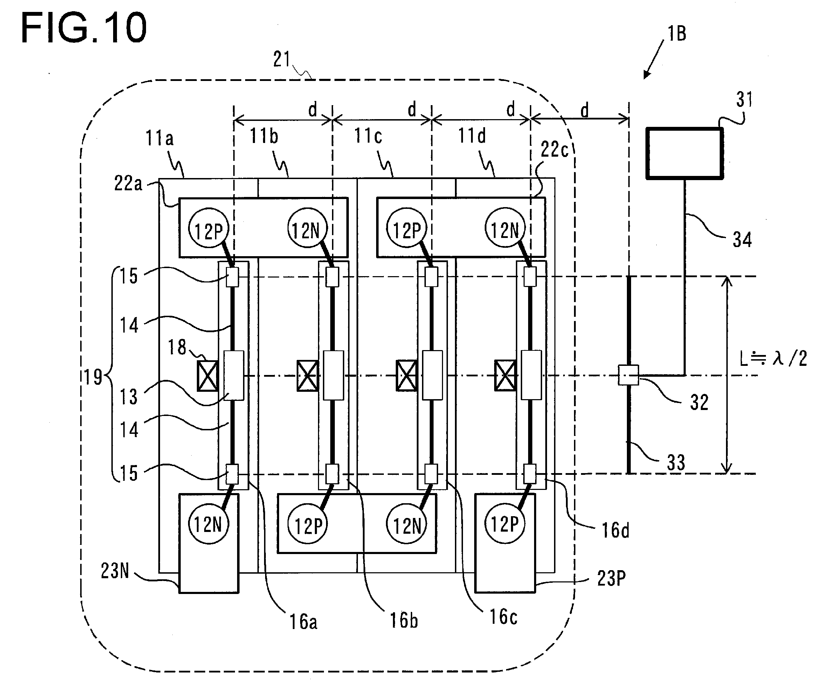

Description will be made with reference to Fig. 10 regarding a configuration of a battery system 1B according to the present embodiment. Fig. 10 is a plan view showing a configuration of the battery system 1B according to the third embodiment of the present invention. The point of difference between the battery system 1B and the battery system 1 described in the first embodiment with reference to Fig. 1 is that each cell 11 included in the battery system 1B has a gas release vent 18.

The gas release vent 18 is configured as an openable vent provided to the top face of a can-type casing housing the cell 11. If the internal pressure in the casing of the cell 11 abnormally rises, the gas release vent 18 opens, thereby releasing gas that occurs in the casing. This allows the gas release vent 18 to provide a function for preventing the pressure in the cell 11 from rising to a danger zone. For example, such a gas release vent 18 may be provided to a central portion of the top face of the casing of the cell 11.

The casing of the cell 11 has an airtight structure. In a case in which the cell 11 enters an abnormal state such as an overheat state, overcharged state, over-discharged state, or the like, in some cases, gas occurs due to vaporization or decomposition of an electrolyte solution, leading to an increase in the internal pressure in the casing. If the internal pressure rises beyond the limit that corresponds to the casing structure, in some cases, the casing breaks, leading to a risk of damaging the surrounding environment. Accordingly, by providing such a gas release vent 18 configured to be closed when the internal pressure is normal and, if the internal pressure abnormally rises to a predetermined value, to open before the casing breaks, the cell 11 is configured to reduce the internal pressure without the casing structure breaking.

In some cases, the gas that can occur in the casing of the cell 11 is a combustible gas or a corrosive gas. Thus, in a case in which the battery system 1B is located in the vicinity of a human being, e.g., in a case in which the battery system 1B is employed as an in-vehicle battery system, the gas thus released via the gas release vent 18 is preferably discharged, by means of a duct or the like (not shown), via a safe location such as a vehicle exterior, instead of the gas being directly discharged to the exterior of the battery system 1B. In this case, the position at which the gas can leak can be determined based on the position at which the gas release vent 18 is formed. This allows a duct layout having high efficiency to be designed.

In a case in which such a gas release vent 18 is provided to the top face portion of the casing of the cell 11 having the configuration as described in the first embodiment with reference to Fig. 1, in some cases, the voltage detection circuit board 16 is arranged such that it covers and blocks the gas release vent 18. In this case, there is a risk of the voltage detection circuit board 16 interfering with the function of the gas release vent 18, which must be avoided as much as possible. In order to solve such a problem, as shown in Fig. 10, each voltage detection circuit board 16 is configured to have as small a width as possible, and is offset horizontally, thereby solving such a layout problem. Alternatively, an opening is formed through each voltage detection circuit board 16 at such a portion that interferes with the gas release vent 18, thereby securing the function of the gas release vent 18. In either case, each voltage detection line 14 that functions as the antenna portion 19 is required to be configured to have a linear structure on the voltage detection circuit board 16. Thus, each gas release vent 18 is provided at a position offset toward the left side or otherwise the right side in the drawing.

It should be noted that the configuration as described above has no effect on the electric characteristics of the voltage detection circuit 13. Thus, the battery system 1B according to the present embodiment has the same electric characteristics and the same configuration as those of the battery system 1 described in the first embodiment. Accordingly, description thereof will be omitted.

With the third embodiment of the present invention described above, such an arrangement provides the same effects and advantages as those in the first embodiment. Furthermore, such an arrangement employs the cells 11 with high safety each including the gas release vent 18. This provides improved safety of the overall battery system.

### [Fourth embodiment]

Next, description will be made with reference to the drawings regarding a battery system according to a fourth embodiment of the present invention. Description will be made in the present embodiment regarding an example in which the waveguide structure includes a dummy antenna 24.

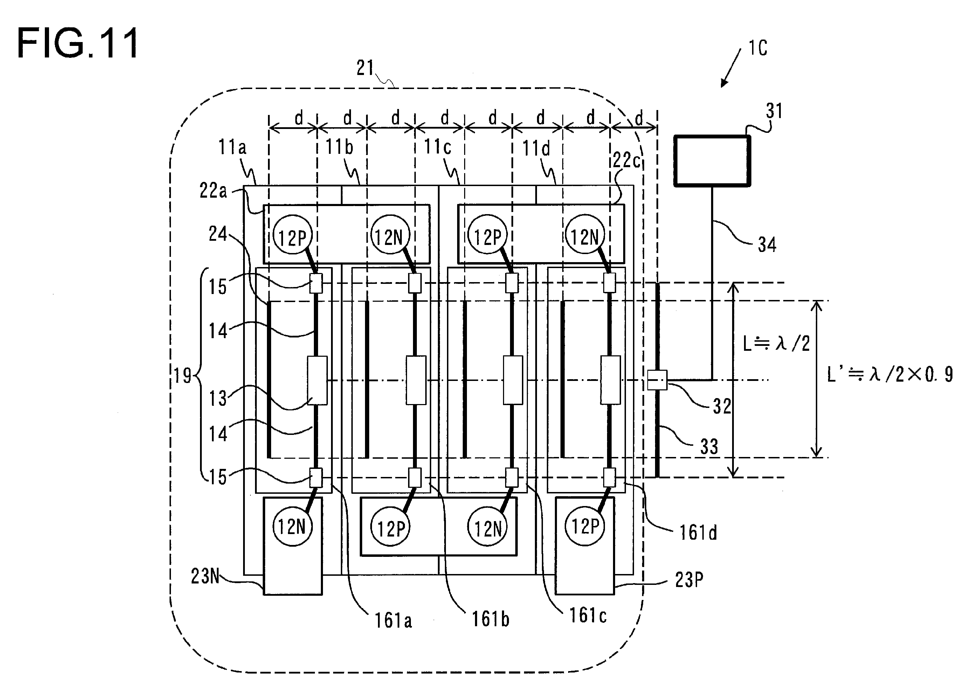

Description will be made below with reference to Fig. 11 regarding a configuration of a battery system 1C according to the present embodiment. Fig. 11 is a plan view showing the configuration of the battery system 1C according to the fourth embodiment of the present invention. The point of difference between the battery system 1C and the battery system 1 described in the first embodiment with reference to Fig. 1 is that the battery system 1C is equipped with voltage detection circuit boards 161a through 161d each including a dummy antenna 24, instead of the voltage detection circuit boards 16a through 16d shown in Fig. 1. This allows the same waveguide structure as that shown in Fig. 3 to be employed, thereby providing improved transmission efficiency for electromagnetic waves even if it is difficult to provide the layout arrangement as described in the first embodiment due to the relation between the thickness of each of the cells 11a through 11d and the wavelength of the carrier wave employed in the wireless communication.

It should be noted that the interval at which the adjacent cells 11 are arranged requires a margin for cooling, the thickness of a fixing structure member configured to fix the cell 11, and the like, in addition to the thickness of the cell 11 itself. In a case in which the interval as determined above is greater than the allowable interval d at which the adjacent antenna portions 19 are arranged as described in the first embodiment, the waveguide structure as shown in Fig. 3 cannot be provided using the method as described in the first embodiment. In order to solve such a problem, the present embodiment employs the voltage detection circuit boards 161a through 161d on which the dummy antenna 24 is mounted in addition to the voltage detection circuit 13, the voltage detection line 14, and the high-frequency cutoff elements 15.

Each dummy antenna 24 is connected to neither the cell 11 nor the voltage detection circuit 13 mounted on the same substrate. That is to say, each dummy antenna 24 is a parasitic conductive member that is not connected to any one of the other circuits. Such a dummy antenna 24 does not has a function for transmitting/receiving electromagnetic waves. Instead, each dummy antenna 24 has a function as a part of the waveguide structure configured to allow electromagnetic waves to propagate.

Each dummy antenna 24 is configured to have a linear structure having a shorter length than that of the antenna portion 19. Each dummy antenna 24 is preferably configured to have a length on the order of 0.9 times the length of the antenna portion 19. That is to say, in a case in which L is approximately represented by λ/2, the length L' of the dummy antenna 24 can be represented by L' ≈ λ/2 × 0.9. It is known that, by configuring each dummy antenna 24 to have a length that is slightly shorter than that of the antenna portion 19 as described above, such an arrangement allows the waveguide structure to have a maximum propagation gain.

Furthermore, as shown in Fig. 11, the dummy antennas 24 and the antenna portions 19 are preferably arranged in parallel at regular intervals d such that each dummy antenna 24 and each antenna portion 19 are alternately arranged. The interval d is preferably set to approximately λ/4 as described above. Furthermore, the centers of the dummy antennas 24 and the centers of the antenna portions 19 are preferably arranged on approximately the same flat plane or otherwise on approximately the same curved plane, as described with reference to Fig. 3.

Such an arrangement as described above allows the interval at which the adjacent antenna portions 19 that correspond to the adjacent cells 11 are arranged to be increased from d to 2d. This allows the interval at which the adjacent cells 11 are arranged to have a margin. Thus, such an arrangement provides a waveguide structure that is capable of providing high-efficiency electromagnetic wave propagation even if each cell 11 has a greater thickness than the interval d. In addition, such an arrangement allows higher-frequency electromagnetic waves such as 5 GHz-band waves to be employed as a carrier wave used in the wireless communication without a need to change the intervals at which the antenna portions 19 are arranged.

Description has been made in the present embodiment regarding an arrangement in which a single dummy antenna 24 is arranged between the two adjacent antenna portions 19 as shown in Fig. 11. However, the present invention is not restricted to such an arrangement in which a single dummy antenna 24 is interposed between the adjacent antenna portions 19. For example, two or more dummy antennas 24 may be interposed between two adjacent antenna portions 19. In a case in which the antenna portions 19 and the dummy antennas 24 are arranged at regular intervals on the order of λ/8 to λ/4, such an arrangement provides high-efficiency propagation efficiency by means of the waveguide structure according to the present invention. Thus, by designing the number of dummy antennas 24 to be interposed between the adjacent antenna portions 29, such an arrangement allows the cells 11 to have various sizes, and allows the carrier wave, which is to be used in the wireless communication, to have various frequencies.

With the fourth embodiment of the present invention described above, such an arrangement provides the same effects and advantages as provided by the first embodiment. In addition, the fourth embodiment provides the following effects and advantages as described in (7).
(7) The battery system 1C further includes a dummy antenna 24 configured as a parasitic conductive member that has a linear structure having a shorter length than that of the antenna portion 19 and arranged in parallel with the two adjacent antenna portions 19 such that it is interposed between the two adjacent antenna portions 19. The centers of the dummy antennas 24 and the centers of the antenna portions 19 that correspond to the multiple cells 11 are preferably positioned on approximately the same plane. Such an arrangement allows a wireless signal to propagate with high efficiency in the wireless communication while allowing the cells 11 which are to be employed to have various sizes, and allowing the carrier wave which is to be used in the wireless communication to have various frequencies.

### [Fifth embodiment]

Next, description will be made with reference to the drawings regarding a battery system according to a fifth embodiment of the present invention. Description will be made in the present embodiment regarding an example configured to allow the voltage of each cell 11 of each cell block to be transmitted from the corresponding voltage detection circuit 13 to the upper controller 31 by means of wireless communication even if there are multiple cell blocks arranged with a distance between them.

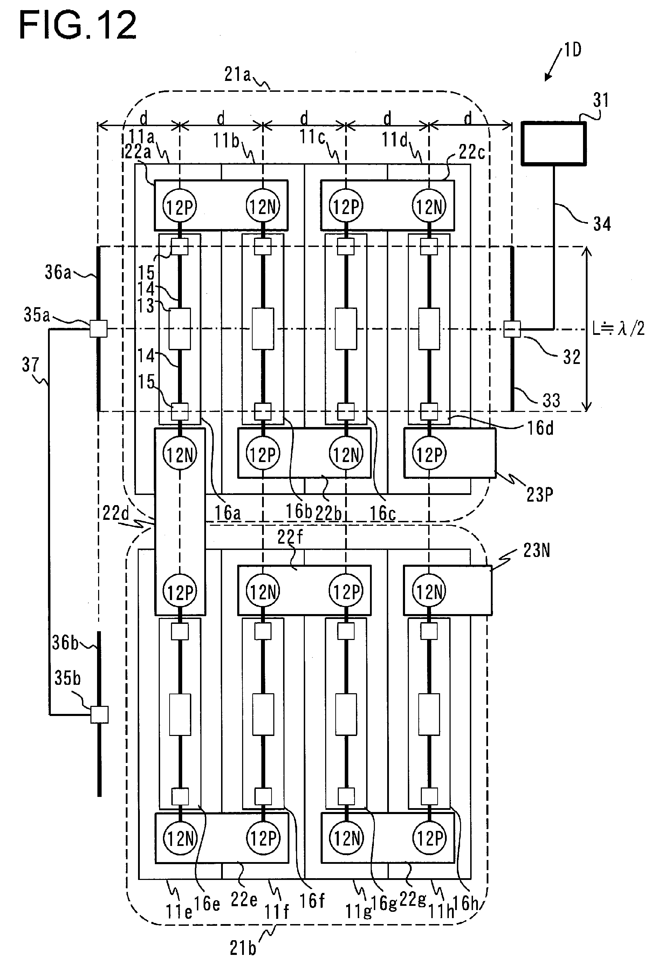

Description will be made with reference to Fig. 12 regarding a configuration of a battery system 1D according to the present embodiment. Fig. 12 is a plan view showing a configuration of the battery system 1D according to the fifth embodiment of the present invention. The point of difference between the battery system 1D and the battery system 1 described in the first embodiment with reference to Fig. 1 is that the cells 11 of the battery system 1D are divided into two cell blocks 21a and 21b, and coupling wireless communication circuits 35a and 35b and coupling antennas 36a and 36b are arranged between the cell blocks 21a and 21b. With such a battery system 1D according to the present embodiment, such an arrangement allows the layout of the cell blocks 21a and 21b to be designed with an improved degree of design freedom.

The cell blocks 21a and 21b have the same configuration as that of the cell block 21 shown in Fig. 1. It should be noted that, in Fig. 12, the cells of the cell block 21a are denoted by reference symbols 11a through 11d, and the voltage detection circuit boards of the cell block 21a are denoted by reference symbols 16a and 16d, as with the cell block 21. Also, the cells of the cell block 21b are denoted by reference symbols 11e through 11h, and the voltage detection circuit boards of the cell block 21b are denoted by reference symbols 16e through 16h.

The cells 11a through 11d of the cell block 21a are connected in series via bus bars 22a, 22b, and 22c. In the same way, the cells 11e through 11h of the cell block 21b are connected in series via bus bars 22e, 22f, and 22g. The negative electrode terminal 12N of the cell 11a, which is on the lowest electric potential side in the cell block 21a, and the positive electrode terminal 12P of the cell 11e, which is on the highest electric potential side in the cell block 21b, are connected to each other via a bus bar 22d. This allows the cells 11a through 11h of the cell blocks 21a and 21b to be connected in series. The positive electrode terminal 12P of the cell 11d is connected to the positive conductor 23P. The negative electrode terminal 12N of the cell 11h is connected to the negative conductor 23N.

As described above, the voltage detection circuit boards 16a through 16h each include the voltage detection line 14 having a part interposed between the high-frequency cutoff elements 15, which functions as the antenna portion 19. The coupling wireless communication circuit 35a receives, via the coupling antenna 36a, a wireless signal that is transmitted from the antenna 33 connected to the upper controller 31, and that is propagated via a waveguide structure comprising the antenna 33 and the antenna portions 19 of the voltage detection circuit boards 16a through 16b of the cell block 21a. Subsequently, the coupling wireless communication circuit 35a generates a relay signal that corresponds to the wireless signal thus received, and transmits the relay signal thus generated to the coupling wireless communication circuit 35b connected via a relay line 37.

Upon reception of the relay signal from the coupling wireless communication circuit 35a, the coupling wireless communication circuit 35b outputs, to the coupling antenna 36b, a high-frequency signal that corresponds to the relay signal. The coupling antenna 36b emits, in the form of electromagnetic waves, the high-frequency signal received from the coupling wireless communication circuit 35b, thereby transmitting the wireless signal to the antenna portions 19 of the voltage detection circuit boards 16e through 16h of the cell block 21b. This allows the wireless signal to be relayed between the waveguide structure including the antenna 33 and the antenna portions 19 of the voltage detection circuit boards 16a through 16d of the cell block 21a and the waveguide structure including the antenna portions 19 of the voltage detection circuit boards 16e through 16h of the cell block 21b.

Description has been made above regarding an arrangement in which a wireless signal is relayed from the cell block 21a to the cell block 21b. Also, such an arrangement allows such a wireless signal to be relayed in the reverse direction. That is to say, when a wireless signal is transmitted from any one of the antenna portions 19 of the voltage detection circuit boards 16e through 16h of the cell block 21b, the wireless signal is received by the wireless coupling communication circuit 35b using the coupling antenna 36b, and is transmitted to the coupling wireless communication circuit 35a via the relay line 37. Subsequently, the wireless signal is transmitted from the coupling wireless communication circuit 35a using the coupling antenna 36a. The wireless signal is transmitted to the antenna 33 via the waveguide structure including the antenna portions 19 of the voltage detection circuit boards 16a through 16b of the cell block 21a.

Either a modulated baseband signal or a high-frequency signal before modulation may be employed as such a relay signal which is input/output between the coupling wireless communication circuits 35a and 35b in the wireless signal relay operation. In a case in which the modulated baseband signal is employed as such a relay signal, by providing a modulation/demodulation function to the coupling wireless communication circuits 35a and 35b, such an arrangement is capable of demodulating a received wireless signal so as to generate a relay signal, and is capable of modulating a relay signal input via the relay line 37 so as to generate a high-frequency signal used to perform wireless communication. On the other hand, in a case in which a high-frequency signal before modulation is employed as such a relay signal, the coupling wireless communication circuits 35a and 35b may each have a circuit configuration that performs only impedance matching between the coupling antennas 36a and 36b and the relay line 37. Thus, such an arrangement has an advantage from the viewpoint of costs and the viewpoint of power consumption, as compared with an arrangement in which a baseband signal is employed as the relay signal.

The coupling antennas 36a and 36b are each configured as a dipole antenna, as with the antenna portions 19 and the antenna 33. Preferably, the coupling antennas 36a and 36b are each configured to have a length L that is approximately equal to λ/2. The coupling antennas 36a and 36b are provided to the cell blocks 21a and 21b, respectively. The coupling antenna 36a is arranged in parallel with the antenna portion 19 (antenna portion 19 that corresponds to the cell 11a in the present embodiment) arranged at a position that is closest to the coupling antenna 36a such that the interval between them is the same as the regular intervals d at which the antenna portions 19 that correspond to the cells 11a through 11d of the cell block 21a are arranged. In the same way, the coupling antenna 36b is arranged in parallel with the antenna portion 19 (antenna portion 19 that corresponds to the cell 11e in the present embodiment) arranged at a position that is closest to the coupling antenna 36b such that the interval between them is the same as the regular intervals d at which the antenna portions 19 that correspond to the cells 11e through 11h of the cell block 21b are arranged. That is to say, the coupling antennas 36a and 36b are each arranged as an extension of the antenna portions 19 according to the same position relation according to which the antenna portions 19 are arranged in the cell blocks 21a and 21b.

As described above, such an arrangement is capable of relaying a wireless signal between the waveguide structure configured including the antenna 33 and the antenna portions 19 of the voltage detection circuit boards 16a through 16d of the cell block 21a and the waveguide structure configured including the antenna portions 19 of the voltage detection circuit boards 16e through 16h of the cell block 21b. Thus, such an arrangement allows the voltage values of the cells 11e through 11h to be transmitted by means of wireless communication from the voltage detection circuit boards 16e through 16h of the cell block 21b to the upper controller 31. This allows the cell blocks 21a and 21b to be arranged in a desired layout. Thus, such an arrangement allows the battery system 1D to have a shape optimized for being mounted on a vehicle. As a result, such an arrangement allows the size and weight of the vehicle to be reduced, thereby providing the vehicle with reduced fuel consumption and reduced power consumption.

Description has been made in the present embodiment regarding an arrangement in which the battery system 1D includes the two cell blocks 21a and 21b. However, the number of cell blocks included in the battery system according to the present invention is not restricted to such an arrangement. For example, three or more cell blocks may be connected to each other in the same manner, thereby configuring a battery system according to the present invention. By providing each cell block with a coupling antenna, and by connecting at least two coupling antennas to each other, such an arrangement is capable of relaying a wireless signal between the waveguide structures of the cell blocks that correspond to the coupling antennas thus connected to each other regardless of the number of cell blocks. It should be noted that the number of coupling antennas connected to each other is not restricted to two. Also, three or more coupling antennas may be connected to each other.

With the fifth embodiment of the present invention described above, such an arrangement provides the same effects and advantages as those provided by the first embodiment. In addition, the fifth embodiment provides the following effects and advantages as described in (8).
(8) In the battery system 1D, the cells 11 are divided into multiple cell blocks 21a and 21b. The cell blocks 21a and 21b are provided with the coupling antennas 36a and 36b, respectively. Each coupling antenna and the antenna portions 19, which correspond to the cells 11a through 11d of the cell block 21a or otherwise correspond to the cells 11e through 11h of the cell block 21b, are arranged at regular intervals d such that the coupling antenna is in parallel with any one of the antenna portions 19. The coupling antenna 36a (36b) is connected to the other coupling antenna 36b (36a). Such an arrangement allows the voltage value of each cell 11 in the cell blocks 21a and 21b to be transmitted from the corresponding voltage detection circuit 13 to the upper controller 31 by means of wireless communication.

### [Sixth embodiment]

Next, description will be made with reference to the drawings regarding a battery system according to a sixth embodiment of the present invention. Description will be made in the present embodiment regarding an example configured to provide wireless communication between each voltage detection circuit and the upper controller 31 without actively emitting electromagnetic waves from each voltage detection circuit.

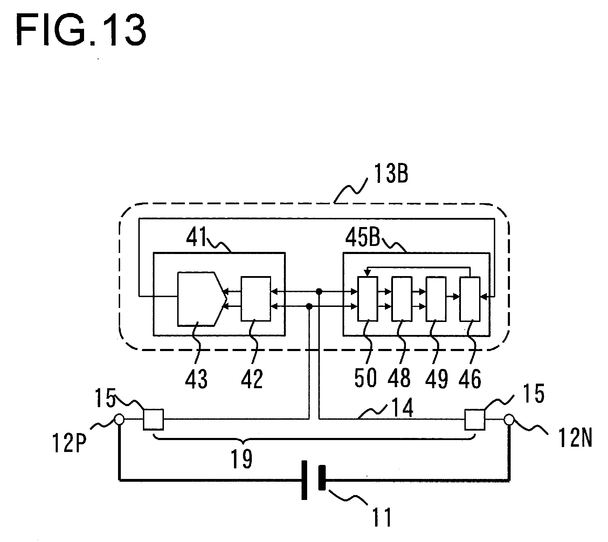

Description will be made below with reference to Fig. 13 regarding a configuration of a voltage detection circuit 13B employed in the battery system according to the present embodiment. Fig. 13 is a wiring diagram showing a circuit block of the voltage detection circuit 13B and a wiring relation between the voltage detection circuit 13B, the cell 11, and the voltage detection line 14 according to the sixth embodiment of the present invention. The point of difference between the voltage detection circuit 13B and the voltage detection circuit 13 described in the first embodiment with reference to Fig. 4 is that the voltage detection circuit 13B includes a wireless communication circuit 45B comprising a communication control unit 46, a demodulation circuit 49, a matching circuit 48, and a high-frequency short-circuiting circuit 50, instead of the wireless communication circuit 45. Such an arrangement allows the battery system according to the present embodiment to provide wireless communication between each voltage detection circuit 13B and the upper controller 31 without actively emitting electromagnetic waves from each voltage detection circuit 13B. Such an arrangement is capable of greatly reducing the power consumption of each voltage detection circuit 13B in the wireless communication operation.

The demodulation circuit 49 is a circuit having only the demodulation function, whereas the modulation/demodulation circuit 47 shown in Fig. 4 has both the modulation function and the demodulation function. The demodulation circuit 49 demodulates a high-frequency signal obtained by receiving, via the antenna portion 19, a wireless signal transmitted from the upper controller 31 using the wireless communication circuit 32 and the antenna 33, so as to generate a reception signal. The reception signal thus generated is output to the communication control unit 46.

The high-frequency short-circuiting circuit 50 is a circuit configured to change a high-frequency impedance as viewed from the antenna portion 19 side, i.e., the impedance with respect to a wireless signal transmitted from the upper controller 31, according to a control operation of the communication control unit 46.

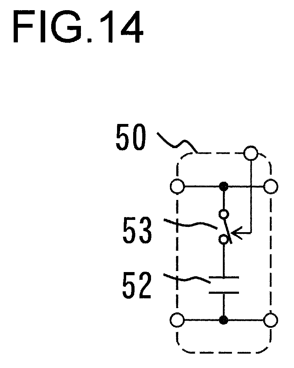

Fig. 14 is a circuit diagram showing an example configuration of the high-frequency short-circuiting circuit 50. As shown in Fig. 14, the high-frequency short-circuiting circuit 50 may be configured as a circuit obtained by connecting a switch element 53 and a capacitor 52 in series, for example. The switch element 53 is an element having a conductive state that can be switched to ON or OFF according to a signal received from the communication control unit 46. The switch element 53 may be configured as an FET (field-effect transistor) or the like, for example. The capacitor 52 has a function of cutting off a DC signal that flows between the positive electrode terminal 12P and the negative electrode terminal 12N, and of allowing a high-frequency signal that flows between the positive electrode terminal 12P and the negative electrode terminal 12N to pass through in the wireless communication.

Next, description will be made regarding the operation of the wireless communication circuit 45B according to the present embodiment. As described in the first embodiment, the wireless signal transmitted using the antenna 33 from the wireless communication circuit 32 connected to the upper controller 31 is propagated to the antenna portion 19 via the waveguide structure as shown in Fig. 3. The wireless communication circuit 45B changes, according to the voltage of the cell 11, the impedance with respect to the wireless signal such that the wireless signal is reflected or otherwise absorbed. This allows the voltage value of the cell 11 to be transmitted to the upper controller 31 in the form of a change in the impedance of the antenna 33 as viewed from the wireless communication circuit 32 without actively emitting electromagnetic waves.

Specifically, in a state in which a high-frequency signal output from the upper controller 31 via the wireless communication circuit 32 is wirelessly transmitted from the antenna 33, the communication control unit 46 controls the switch element 53 so as to switch its conductive state according to a bit value of the communication data. For example, when the communication data that represents "1" is to be transmitted, the switch element 53 is turned on. When the communication data that represents "0" is to be transmitted, the switch element 53 is turned off. Such an operation is repeatedly performed according to a predetermined bit rate, thereby allowing the communication data that represents the voltage value of the cell 11 to be transmitted from the wireless communication circuit 45B to the upper controller 31.

When the switch element 53 is turned on, the antenna portion 19 enters a short-circuited state for high-frequency signals in which the antenna portion 19 is short-circuited via the capacitor 52. In this state, there is no characteristic impedance matching between the antenna portion 19 and the wireless communication circuit 45B. Thus, the wireless signal reflected from the antenna portion 19 is dominant as compared with the wireless signal absorbed by the antenna portion 19. That is to say, the impedance of the antenna 33 becomes high as viewed from the wireless communication circuit 32 connected to the upper controller 31. By monitoring such a state by means of the wireless communication circuit 32, the upper controller 31 is capable of detecting that the communication data that represents "1" has been transmitted from the voltage detection circuit 13B.

On the other hand, when the switch element 53 is turned off, the antenna portion 19 enters a state in which the antenna portion 19 is connected to the matching circuit 48. This provides characteristic impedance matching between the antenna portion 19 and the wireless communication circuit 45B. In this state, the antenna portion 19 absorbs the wireless signal with high efficiency. That is to say, the impedance of the antenna 33 becomes low as viewed from the wireless communication circuit 32 connected to the upper controller 31. By monitoring such a state by means of the wireless communication circuit 32, the upper controller 31 is capable of detecting that the communication data that represents "0" has been transmitted from the voltage detection circuit 13B.

As described above, each voltage detection circuit 13B is capable of transmitting the voltage information with respect to the corresponding cell 11 to the upper controller 31.

It should be noted that the present embodiment is configured as shown in Fig. 14 such that, when the switch element 53 is turned on in the high-frequency short-circuiting circuit 50, the antenna portion 19 is short-circuited via the capacitor 52. Also, in a case in which the electric power of the wireless signal to be received by the antenna portion 19 is great and has a risk of exceeding the rated power of the capacitor 52 or the like, a modification such as the addition of a resistor connected in series with the capacitor 52 may be made.

With the sixth embodiment of the present invention described above, such an arrangement provides the same effects and advantages as those provided by the first embodiment. In addition, the sixth embodiment provides the following effects and advantages as described in (9).
(9) The voltage detection circuit 13B changes the impedance with respect to the wireless signal transmitted from the upper controller 31 by means of the wireless communication circuit 45B according to the voltage value of the cell 11, so as to provide wireless communication. Thus, such an arrangement provides reduced power consumption in an operation for transmitting the voltage information of the cell 11 from the voltage detection circuit 13B to the upper controller 31.

It should be noted that each embodiment or each modification as described above may be applied alone. Also, various kinds of combinations of such embodiments and modifications may be applied.

The embodiments and various kinds of modifications described above have been described for exemplary purposes only. The present invention is by no means restricted to the contents of such embodiments and modifications so long as they do not damage the features of the present invention.

### REFERENCE SIGNS LIST

1, 1A, 1B, 1C, 1D: battery system
11, 11a, 11b, 11c, 11d, 11e, 11f, 11g, 11h: cell
12P: positive electrode terminal
12N: negative electrode terminal
13, 13A, 13B: voltage detection circuit
14: voltage detection line
15: high-frequency cutoff element
16, 16a, 16b, 16c, 16d, 16e, 16f, 16g, 16h, 160, 161a, 161b, 161c, 161d: voltage detection circuit board
17: low-frequency separation circuit
18: gas release vent
19: antenna portion
21, 21a, 21b: cell block
22a, 22b, 22c, 22d, 22e, 22f, 22g: bus bar
23P: positive conductor
23N: negative conductor
24: dummy antenna
31: upper controller
32: wireless communication circuit
33: antenna
34 wiring
35a, 35b: coupling wireless communication circuit
36a, 26b: coupling antenna
37: relay line
41A, 41B: DC voltage detection circuit
42: low-pass filter
43: A/D converter
44: multiplexer
45, 45B: wireless communication circuit
46: communication control unit
47: modulation/demodulation circuit
48: matching circuit
49: demodulation circuit
50: high-frequency short-circuiting circuit
51: inductor
52: capacitor
53: switch element

## Claims

1. A battery system comprising:
a plurality of cells each having a positive electrode terminal and a negative electrode terminal;
a voltage detection circuit that detects a voltage of the cell;
voltage detection lines that are provided to each of the cells and that connect the positive electrode terminal and the negative electrode terminal of each cell to the voltage detection circuit; and
an upper controller that performs wireless communication with the voltage detection circuit so as to receive a voltage value of each corresponding cell from the voltage detection circuit, wherein:
the voltage detection lines each function as an antenna used to provide wireless communication between the voltage detection circuit and the upper controller.

2. The battery system according to Claim 1, wherein:
high-frequency cutoff elements that cut off a predetermined high-frequency current are provided to the voltage detection lines between the positive electrode terminal and the voltage detection circuit and between the negative electrode terminal and the voltage detection circuit respectively; and
a part of the voltage detection line interposed between the high-frequency cutoff elements provides an antenna portion that functions as the antenna.

3. The battery system according to Claim 2, wherein:
the antenna portion has a linear structure having a length that is approximately equal to half a wavelength of a carrier wave used in the wireless communication.

4. The battery system according to Claim 2 or 3, wherein:
the antenna portions that respectively correspond to the plurality of cells are arranged in parallel at regular intervals.

5. The battery system according to Claim 4, wherein:
each of the centers of the antenna portions that respectively correspond to the plurality of cells are arranged on approximately the same plane.

6. The battery system according to Claim 5, wherein:
a parasitic conductor that has a linear structure having a shorter length than that of the antenna portion is provided between two adjacent antenna portions such that it is arranged in parallel with the two antenna portions; and
a center of the parasitic conductor and each of the centers of the antenna portions that respectively correspond to the plurality of cells are arranged on approximately the same plane.

7. The battery system according to Claim 4, wherein:
the plurality of cells are divided into a plurality of blocks;
a coupling antenna is provided to each of the plurality of blocks such that the coupling antenna and the antenna portions that respectively correspond to the cells of the corresponding block are arranged at regular intervals, and such that it is arranged in parallel with any one from among the antenna portions; and
the coupling antenna is connected to another coupling antenna.

8. The battery system according to Claim 2 or 3, wherein:
the high-frequency cutoff element is configured as a resonance circuit comprising an inductor and a capacitor connected in parallel; and
the resonance circuit has a resonance frequency that is approximately equal to a frequency of a carrier wave used in the wireless communication.

9. The battery system according to any one of Claims 1 through 3, wherein:
the voltage detection circuit comprises a wireless communication circuit that generates a wireless signal modulated according to the voltage of the cell; and
the wireless signal is transmitted from the voltage detection circuit to the upper controller so as to perform the wireless communication.

10. The battery system according to any one of Claims 1 through 3, wherein:
the voltage detection circuit changes, according to the voltage of the cell, an impedance for a wireless signal transmitted from the upper controller so as to perform the wireless communication.
